Europäisches Patentamt

European Patent Office

Office européen des brevets

(19)

(11) Numéro de publication: **0 263 010**
**B1**

(12) **FASCICULE DE BREVET EUROPEEN**

(45) Date de publication du fascicule du brevet: **16.01.91**

(51) Int. Cl.⁵: **H 05 K 9/00, H 02 K 47/20**

(21) Numéro de dépôt: **87402057.1**

(22) Date de dépôt: **15.09.87**

(54) **Dispositif d'alimentation en électricité d'appareils placés à l'intérieur d'une cage de faraday.**

(30) Priorité: **25.09.86 FR 8613390**

(43) Date de publication de la demande:
**06.04.88 Bulletin 88/14**

(45) Mention de la délivrance du brevet:
**16.01.91 Bulletin 91/03**

(84) Etats contractants désignés:
**AT BE CH DE ES GB GR IT LI LU NL SE**

(56) Documents cités:
**DE-A-2 608 542**
**DE-A-2 903 798**
**FR-A- 887 562**
**FR-A-2 223 939**
**US-A-1 994 905**

(73) Titulaire: **SIEPEL - Société Industrielle d'Etudes et Protection Electronique**
**Kermarquer**
**F-56470 La Trinité-sur-Mer (FR)**

(72) Inventeur: **Ruelle, Philippe**
**Bransquel-Pluneret**
**F-56400 Auray (FR)**

(74) Mandataire: **Fruchard, Guy et al**
**CABINET BOETTCHER 23, rue la Boétie**
**F-75008 Paris (FR)**

Courier Press, Leamington Spa, England.

## Description

La présente invention concerne un dispositif d'alimentation en électricité d'une cage de Faraday.

On sait que la propriété principale d'une cage de Faraday est de former une barrière isolante aux ondes électromagnétiques entre l'intérieur et l'extérieur de la cage de Faraday. Cette propriété est utilisée soit pour éviter qu'un signal électromagnétique émis à l'intérieur de la cage de Faraday ne puisse être capté à l'extérieur, c'est le cas en particulier lorsque l'on veut garder le secret sur des messages transmis par des moyens de télécommunication; soit pour protéger l'intérieur de la cage contre une influence électromagnétique extérieure, par exemple pour protéger des appareils sensibles aux ondes électromagnétiques contre une attaque nucléaire déclenchant un orage magnétique.

Le principal problème dans l'utilisation des cages de Faraday est l'alimentation en électricité des appareils disposés à l'intérieur de la cage. En effet, si l'on se contente de passer un câble d'alimentation électrique à travers la paroi de la cage de Faraday, même si l'ouverture dans la paroi a des dimensions appropriées pour former un guide d'ondes le câble électrique est soumis aux rayonnements électromagnétiques de part et d'autre de la paroi et transmet ceux-ci par conduction sur le côté opposé.

Pour éviter la transmission des ondes électromagnétiques par l'intermédiaire du câble d'alimentation en électricité, on a déjà effectué l'alimentation en électricité des cages de Faraday à travers des filtres disposés au niveau de la paroi de la cage et dont le boîtier est relié à la paroi de la cage. Toutefois, ces filtres, généralement constitués de condensateurs et d'inductances, ne sont adaptés qu'à certaines fréquences des ondes électromagnétiques et ont donc un effet de filtrage limité. De plus, les courants de fuite de ces filtres, qui peuvent être importants, se retrouvent dans la mise à la masse de la cage et peuvent donc être récupérés à l'extérieur de la cage et décodés pour en extraire les informations résultant des ondes électromagnétiques émises à l'intérieur de la cage.

Un but de la présente invention est de réaliser un dispositif d'alimentation en électricité d'une cage de Faraday qui ne transmette aucun phénomène électromagnétique entre l'intérieur et l'extérieur de la cage de Faraday.

En vue de la réalisation de ce but, on prévoit un dispositif d'alimentation en électricité d'une cage de Faraday comprenant un générateur, électrique, un moteur d'entraînement du générateur, et des moyens d'accouplement mécanique du générateur et du moteur, qui, selon un premier mode de réalisation, est caractérisé en ce que le générateur est entouré par un boîtier conducteur constituant un élément de blindage électromagnétique électriquement isolé du moteur d'entraînement qui est disposé à l'extérieur de cet élément de blindage moteur et générateur étrant situés à l'exterieur de la cage de Faraday, en ce que l'élément de blindage électromagnétique est relié électriquement à une paroi de la cage de Faraday par une gaine tubulaire conductrice dans laquelle s'étend un câble de liaison du générateur avec l'intérieur de la cage de Faraday, et en ce que les moyens d'accouplement mécanique sont électriquement isolants et s'étendent dans des passages en guide d'onde de l'élément de blindage électromagnétique, et, selon un second mode de réalisation, est caractérisé en ce que le générateur est disposé à l'intérieur de la cage de Faraday et le moteur est disposé à l'extérieur de la cage de Faraday et est électriquement isolé de celle-ci, et en ce que les moyens d'accouplement mécanique sont élecquement isolants et traversent une paroi de la cage de Faraday dans des passages en guide d'ondes.

Un untre mode de réalisation de l'invention est décrit dans la revendication 2.

D'autres caractéristiques et avantages de l'invention apparaîtront encore à la lecture de la description qui suit en liaison avec les dessins ci-joints parmi lesquels:

la figure 1 est une vue en perspective d'un premier mode de réalisation du dispositif selon l'invention,

la figure 2 est une vue en coupe selon la ligne II-II de la figure 1,

la figure 3 est une illustration schématique d'un second mode de réalisation du dispositif selon l'invention.

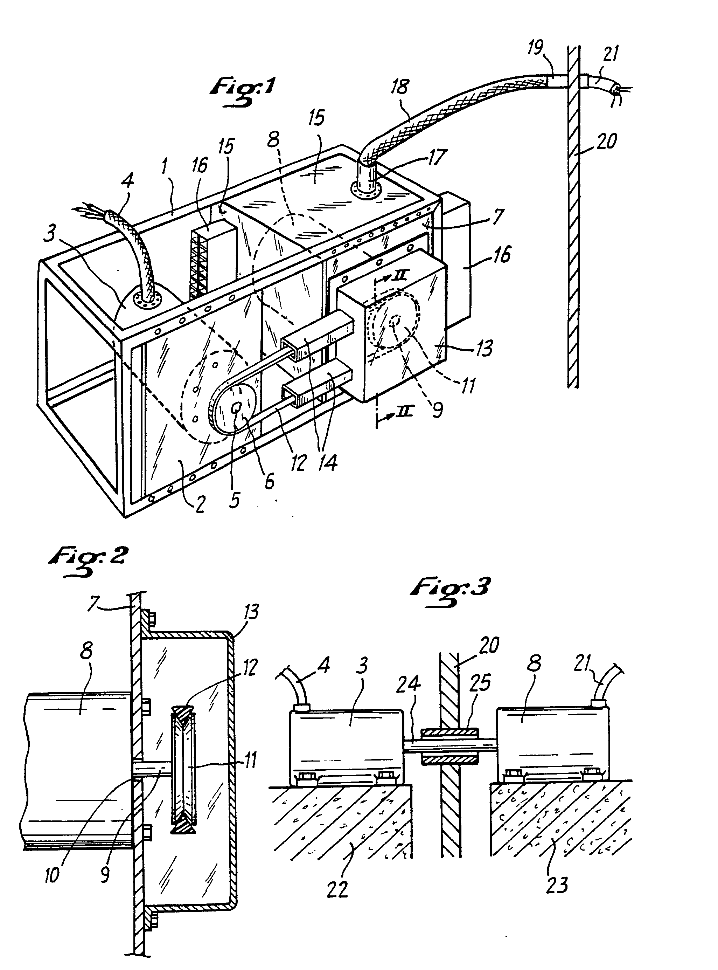

En référence aux figures 1 et 2, selon un premier mode de réalisation, le dispositif comporte un châssis parallélépipédique 1 réalisé à partir de cornières en L. Une plaque électriquement isolante 2 est fixée sur une face du châssis et supporte un moteur électrique 3 relié au réseau électrique par un câble électrique traditionnel 4. L'arbre 5 du moteur électrique 3 passe à travers la paroi isolante 2 et supporte une poulie d'entraînement 6.

Une plaque électriquement conductrice 7, par exemple une plaque en laiton, est fixée sur la même face du châssis 1 que la plaque isolante 2 et supporte un générateur électrique 8, par exemple un alternateur. L'arbre 9 de l'alternateur 8 passe à travers une ouverture 10 de la plaque 7 et supporte une poulie 11. La poulie d'entraînement 6 et la poulie de l'alternateur 11 sont réunies par une courroie isolante 12. Un capot 13 électriquement conducteur, par exemple un capot en laiton, est fixé sur la plaque conductrice 7 et entoure la poulie 11 ainsi qu'une partie de la courroie 12. Au niveau du passage des deux brins de la courroie 12 à travers la paroi latérale du capot 13, celui-ci comporte des passages en guide d'ondes 14.

Une série de plaques conductrices 15, par exemple des plaques en laiton, sont fixées entre elles et à la plaque conductrice 7 tout autour du générateur 8 et forment un boîtier conducteur entourant celui-ci. Les deux plaques latérales 15 comportent un réseau d'ouvertures en guide d'ondes 16 qui servent à la ventilation du boîtier contenant le générateur 8. La plaque conductrice supérieure 15 est percée d'une ouverture sur laquelle est monté un manchon guide d'ondes 17 sur lequel est soudée une gaine tubulaire conductrice 18 dont l'extrémité opposée au manchon 17 est soudée à un second manchon conducteur en guide d'ondes 19 traversant une paroi 20 de la cage de Faraday. Un câble électrique 21 s'étend dans la gaine conductrice 18 et à l'intérieur des manchons 17 et 19 et relie le générateur à l'intérieur de la cage de Faraday.

On remarque qu'en raison de la liaison de la plaque supèrieure conductrice 15 à la paroi 20 de la cage de Faraday par la gaine conductrice 18, le boîtier entourant le générateur 8 est au même potentiel que la cage de Faraday et, du point de vue électromagnétique, le générateur 8 se trouve donc dans une situation équivalente à celle qu'il aurait en étant disposé physiquement à l'intérieur de la cage de Faraday. Les rayonnements électromagnétiques auxquels le câble 21 peut être soumis à l'intérieur de la cage de Faraday sont donc transmis par conduction jusqu'au générateur mais ne sont pas transmis par la courroie 12 et ne peuvent donc être détectés au niveau du câble d'alimentation 4 du moteur 3.

La figure 3 illustre un autre mode de réalisation de l'invention dans lequel le moteur 3 est fixé sur un socle 22 à l'extérieur de la cage de Faraday tandis que le générateur 8 est fixé sur un socle 23 à l'intérieur de la cage de Faraday, la paroi 20 de la cage de Faraday s'étendant entre le moteur 3 et le générateur 8. Le moteur 3 et le générateur 8 sont cette fois montés en regard l'un de l'autre et l'entraînement est effectué par un arbre unique 24 en matériau isolant. L'arbre 24 s'étend dans un guide d'ondes 25 réalisé dans la paroi 20. Dans ce cas il n'est pas nécessaire de prévoir de gaine conductrice sur le câble 21.

Bien entendu l'invention n'est pas limitée aux modes de réalisation décrits ci-dessus et on peut y apporter des variantes de réalisation sans sortir du cadre de l'invention. En particulier, dans l'exemple de rèalisation des figures 1 et 2, le capot 13 peut être supprimé à condition de réaliser l'ouverture 10 de la plaque 7 sous forme d'un guide d'ondes et de prévoir un axe 9 en matière isolante.

Par ailleurs, bien que l'invention ait été décrite en liaison avec un moteur d'entraînement 3 à alimentation électrique, on peut bien entendu prévoir un moteur de toute autre nature, par exemple un moteur à gaz comprimé ou un moteur thermique.

## Revendications

1. Dispositif d'alimentation en électricité d'une cage de Faraday comprenant un générateur électrique (8), un moteur d'entraînement (3) du générateur, et des moyens d'accouplement mécanique du générateur et du moteur caractérisé en ce que le générateur est entouré par un boîtier conducteur constituant un élément de blindage électromagnétique (7, 13, 15, 16) électriquement isolé du moteur d'entraînement qui est disposé à l'extérieur de cet élément de blindage moteur et générateur étant situés à l'extérieur de la cage de Faraday, en ce que l'élément de blindage électromagnétique est relié électriquement à une paroi (20) de la cage de Faraday par une gaine tubulaire conductrice (18) dans laquelle s'étend un câble de liaison (21) du générateur avec l'intérieur de la cage de Faraday, et en ce que les moyens d'accouplement mécanique (12) sont électriquement isolants et s'étendent dans des passages en guide d'onde (14) de l'élément de blindage électromagnétique.

2. Dispositif d'alimentation en électricité d'une cage de Faraday comprenant un générateur électrique (8) un moteur d'entraînement (3) du générateur, et des moyens d'accouplement mécanique du générateur et du moteur, caractérisé en ce que le générateur est disposé à l'intérieur de la cage de Faraday et le moteur est disposé à l'extérieur de la cage de Faraday et est électriquement isolé de celle-ci, et en ce que les moyens d'accouplement mécanique (24) sont électriquement isolants et traversent une paroi de la cage de Faraday dans des passages en guide d'ondes (25).

## Patentansprüche

1. Einrichtung zur elektrischen Stromversorgung eines Faraday'schen Käfigs, umfassend einen elektrischen Generator (8), einen Antriebsmotor (3) für den Generator, und Mittel zum mechanischen Kuppeln des Generators mit dem Motor, dadurch gekennzeichnet,
daß der Generator von einem leitfähigen Gehäuse umgeben ist, welches eine elektromagnetische Abschirmung (7, 13, 15, 16) bildet, die von dem außerhalb dieser Abschirmung angeordneten Antriebsmotor elektrisch isoliert ist, wobei der Motor und der Generator außerhalb des Faraday'schen Käfigs angeordnet sind,
daß die elektromagnetische Abschirmung mit einer Wand (20) des Faraday'schen Käfigs über eine leitfähige rohrförmige Ummantelung (18) elektrisch verbunden ist, in welcher ein Verbindungskabel (21) des Generators mit dem Inneren des Faraday'schen Käfigs verläuft,
und daß die Mittel (12) zum mechanischen Ankuppeln elektrisch isolierend sind und in Wellenhohlleiter-Kanälen (14) der elektromagnetischen Abschirmung verlaufen.

2. Einrichtung zur elektrischen Stromversorgung eines Faraday'schen Käfigs, umfassend einen elektrischen Generator (8), einen Antriebsmotor (3) für den Generator und Mittel zum mechanischen Kuppeln des Generators mit dem Motor, dadurch gekennzeichnet, daß der Generator des Faraday'schen Käfigs innerhalb des Faraday'schen Käfigs angeordnet und der Motor außerhalb des Faraday'schen Käfigs angeordnet und von diesem elektrisch isoliert ist, und daß die Mittel (24) zum mechanischen Kuppeln elektrisch isolierend sind und in Wellenhohlleiter-Kanälen (25) verlaufend durch eine Wand des Faraday'schen Käfigs hindurchgeführt sind.

**Claims**

1. A device for feeding electricity into a Faraday cage, the device comprising an electrical generator (8), a generator drive motor (3), and mechanical coupling means for coupling the generator and the motor, characterized in that the generator is surrounded by a conductive housing forming an electromagnetic screening element (7, 13, 15, 16) which is located outside of the screening element, the motor and generator being located outside the Faraday cage, in that the electromagnetic screening element is electrically connected to a wall (20) of the Faraday cage by a conducting tubular sheath (18) inside which there extends a cable (21) connecting the generator to the inside of the Faraday cage, and in that the mechanical coupling means (12) is electrically insulating and extends within waveguide passages (14) of the electromagnetic screening element.

2. A device for feeding electricity into a Faraday cage, the device comprising an electrical generator (8), a generator drive motor (3), and mechanical coupling means for coupling the generator and the motor, characterized in that the generator is located inside the Faraday cage and the motor is located outside the Faraday cage and is electrically insulated therefrom, and in that the mechanical coupling means (24) is electrically insulating and extends through a wall of the Faraday cage within waveguide passages (25).

*Fig:1*

*Fig:2*

*Fig:3*